Europäisches Patentamt

European Patent Office

Office européen des brevets

(19)

(11) EP 0 729 035 A2

(12) **EUROPÄISCHE PATENTANMELDUNG**

(43) Veröffentlichungstag:
28.08.1996 Patentblatt 1996/35

(51) Int. Cl.6: **G01R 31/317**

(21) Anmeldenummer: 96102162.3

(22) Anmeldetag: 14.02.1996

(84) Benannte Vertragsstaaten:
AT BE CH DE FR GB IT LI NL SE

(30) Priorität: 24.02.1995 DE 19506432
22.12.1995 DE 19548277
31.08.1995 DE 29513955 U

(71) Anmelder: **Langer, Gunter**
**D-01728 Bannewitz (DE)**

(72) Erfinder: **Langer, Gunter**
**D-01728 Bannewitz (DE)**

(74) Vertreter: **Heyner, Klaus, Dr.-Ing.**
**Oelsaer Weg 36**
**01189 Dresden (DE)**

(54) **Feldquelle zur Untersuchung der elektromagnetischen Verträglichkeit**

(57)   Beschrieben wird der Aufbau von Feldquellen zur Erzeugung lokaler, pulsartiger magnetischer oder elektrischer Felder, wie sie für Untersuchungen zur elektromagnetischen Verträglichkeit elektronischer Schaltungen, Baugruppen und Geräte benötigt werden. Es handelt sich dabei um die Einkopplung eines in seinen Parametern verstellbaren elektrischen bzw. magnetischen (Puls-)Feldes mit dem Ziel, gegenüber Störeinwirkungen empfindliche Stellen des Prüflings bereits im Entwicklungsstadium zu dedektieren und wirksame Gegenmaßnahmen einzuleiten.

Die Grundanordnung der Feldquelle besteht aus einer Sonde (1) zur Bereitstellung lokaler, pulsartiger B- und/oder E-Felder, einem Verbindungskabel (35) zum Störimpulsgenerator (2), der die Strom- oder Spannungsimpulse erzeugt, die über das Verbindungskabel der die Induktionsspule (3) oder die Platte bzw. das Plattenpaar (4) enthaltenden Sonde zugeführt werden, und dem Störimpulsgenerator (2) selbst.

Diese Grundanordnung soll in ein kompaktes, handliches ergonomisch zweckmäßiges und leicht bedienbares Gerät integriert werden. In einer bevorzugten Ausführungsform hat das Gerät eine stiftartige Gestalt, wobei in der Stiftspitze die ggf. auswechselbare Sonde (1) angeordnet ist. Der weitere Aufbau und Schaltungen für das als Feldquelle arbeitende Gerät werden erläutert.

FIG. 12.2

**Beschreibung**

Die Erfindung bezieht sich auf den Aufbau von Feldquellen zur Erzeugung lokaler, pulsartiger magnetischer oder elektrischer Felder, wie sie für Untersuchungen zur elektromagnetischen Verträglichkeit elektronischer Schaltungen, Baugruppen und Geräte benötigt werden.
Es handelt sich dabei um die Einkopplung eines in seinen Parametern verstellbaren elektrischen bzw. magnetischen Pulsfeldes im Nahbereich mit dem Ziel, gegenüber Störeinwirkungen empfindliche Stellen des Prüflings bereits im Entwicklungsstadium zu dedektieren und wirksame Gegenmaßnahmen einzuleiten.

Geräte, die von der vorliegenden Erfindung Gebrauch machen, werden eingesetzt zum Testen bzw. Ausmessen schneller Digitalschaltungen.
Sie gestatten die Durchführung von Störfestigkeitsprüfungen bezüglich elektrostatischer Entladungen bzw. die Ausmessung der Gerätefestigkeit gegenüber schnellen transienten Vorgängen wie Burstimpulse. Die erzeugten Magnetfelder können in den niederohmigen Schleifen der digitalen Signalleiterzüge Störspannungen induzieren, die für Beeinflussungen ausreichen.

Im EMV Journal No. 3 von 1993 wird auf Seite 166 über H-Feld- und E-Feldsonden informiert, die zur Diagnose von Emissionen und zur Erzeugung periodisch sinusförmiger Felder zur Untersuchung der Störstrahlungsempfindlichkeit von elektronischen Geräten eingesetzt werden sollen.

In P 44 17 031.9 sind der Aufbau und die Anwendungen von Feldquellen für die Erzeugung eines elektrischen (E) oder magnetisches Feldes (B) beschrieben, die für Untersuchungen zur elektromagnetischen Verträglichkeit (EMV) von elektronischen Schaltungen dienen.
Diese Feldquellen liefern auf kleine Raumbereiche konzentriert sinusförmige E- und/oder B-Felder. Die Feldquellen sind in einer Sonde enthalten, von deren Oberfläche das Feld ausgeht.

Zur Erzeugung eines B-Feldes dient eine Induktionsspule, die von einem periodisch sinusförmigen Strom durchflossen wird und einen Durchmesser von 1 ... 5 cm aufweist. Der Strom baut in Verbindung mit der Spule ein sinusförmiges Magnetfeld B auf. Das Magnetfeld wird durch entsprechende Führung der die Spule enthaltenden Sonde partiell in die zu untersuchende elektronische Schaltung eingekoppelt.

Zur Erzeugung eines elektrischen Feldes E dient in analoger Weise eine Metallplatte oder ein Metallplattenpaar, welches mit einer periodisch sinusförmigen Spannung gespeist wird. Die Platte oder das Plattenpaar baut ein sinusförmiges elektrisches Feld E auf. Die Sonden können in die Nähe von elektronischen Schaltungen gebracht werden. Eine partielle Einkopplung in kleine räumliche Gebiete, wie in den Chip eines integrierten Schaltkreises (IC) oder in Leiterzüge, kann durchgeführt werden.

Aufgabe der Erfindung ist es, zur Durchführung von Störfestigkeitsprüfungen bei schnellen niederohmigen Digitalschaltungen ein sowohl kompaktes als auch handliches Gerät zusammen mit der zugehörigen Schaltungstechnik vorzuschlagen, das es ermöglicht, die auf elektromagnetische Verträglichkeit zu prüfenden Bereiche der zu untersuchenden Digitalschaltungen selektiv mit pulsartigen Feldern vom Charakter einer elektrostatischen Entladung oder eines Burstimpulses zu beaufschlagen.

Eine erfindungsgemäße Lösung dieser Aufgabe ist im Patentanspruch 1 angegeben. Weiterbildungen der Erfindung sind in den Unteransprüchen gekennzeichnet.

Die Grundanordnung der Feldquelle nach Patentanspruch 1 besteht aus einer Sonde zur Bereitstellung lokaler, pulsartiger B- und/oder E-Felder, einem Verbindungskabel zum Störimpulsgenerator, der die Strom- oder Spannungsimpulse mit Anstiegs- und Rückenzeiten im Nanosekundenbereich erzeugt, die über das Verbindungskabel der die Induktionsspule oder die Platte bzw. das Plattenpaar enthaltenden Sonde zugeführt werden, und dem Störimpulsgenerator selbst.

Diese Grundanordnung soll in ein kompaktes, handliches ergonomisch zweckmäßiges und leicht bedienbares Gerät integriert werden. In einer bevorzugten Ausführungsform hat das Gerät eine stiftartige Gestalt, wobei in der Stiftspitze die Sonde angeordnet ist. Der weitere Aufbau und die Schaltung für das als Feldquelle arbeitende Gerät wird nachfolgend beschrieben.

Die die Sonde enthaltende Gerätespitze ist in ihrer Größe und Anordnung am Gerät so beschaffen, daß in oder zwischen die zu prüfenden elektronischen Bauelemente ein E- oder B-Feld eingekoppelt werden kann, so z.B. in Leiterzüge, in einzelne Pins von integrierten Schaltungen und in Chip's integrierter Schaltungen.

Das Gerät kann Bedienelemente zur Verstellung der Parameter des pulsartigen Feldes besitzen; zu den Parametern gehören die Pulsfrequenz, Anstieg und Amplitude der Strom- bzw. Spannungsimpulse und die Auslösung von Einzelimpulsen. Das Gerät kann batteriebetrieben, d.h. netzunabhängig sein und benötigt in dieser Ausführung keine externen Leitungsverbindungen.

Anstelle der Induktionsspule zur Erzeugung pulsartiger magnetischer Felder kann zur Erzeugung pulsartiger elektrischer Felder ein elektrisch leitfähiges Platten- oder Stabpaar verwendet werden (Ansprüche 4 und 5). Dabei kann das Plattenpaar analog einem Plattenkondensator aufgebaut sein. Die Platten können aber auch in gestreckter bzw. linienförmger Ausführung in einer Ebene nebeneinander oder hintereinander angeordnet sein. Die hintere Platte kann in Ihrer Ebene um 90° gedreht sein und die Platten können eine unterschiedliche Größe besitzen. Jeder der beiden Anschlüsse, die für die Induktionsschleife vorgesehen sind, wird mit je einer Platte des Plattenkondensators verbunden.

Bei einer für Stiftsonden bevorzugten Ausführungsform wird die Funktion der zweiten (hinteren) Koppelplatte von den im Inneren des Gehäuses der Feldquelle befindlichen Metallteilen ausgeübt.

Eine Platte des Kondensators kann auch von den leitfähigen Teilen des Gerätes, der Baugruppe, also des Prüflings, gebildet werden, so daß in diesem Spezialfall im Gehäuse der Feldquelle nur eine Platte enthalten ist. Die Platte kann über ein Gelenk oder ein flexibles Verbindungsstück mit einem Griffstab verbunden werden. Das Gelenk ermöglicht es, den Winkel der Platte zum Griffstab mit geringem Kraftaufwand zu verstellen. Die Form der Platte ist rechteckförmig und weist ggf. eine Spitze auf. Die Größe kann 1 bis 10 Zentimeter betragen, s. Anspruch 6.

Bei der Ausführung als Plattenpaar kann die Form der Platten lanzettenförmig oder ähnlich einer Rechteckform ausgebildet sein, die an einer Seite spitz auslaufen kann. Weiterhin ist eine schmale, ca 1 mm breite und 5 mm lange stegartige Form günstig. Für eine 90° Winkelausführung (Winkel zwischen Plattenebene und Griffstab) ist eine ca. 2 mm kreisrunde Ausführung vorgesehen.

Bei einer speziellen Ausführung der Sonde betrifft die 90°-Winkelanordnung lediglich die Position des Griffstabes zur am Applizierende der Feldsonde befindlichen Einkoppelplatte. Die zweite Platte des Plattenpaares befindet sich als Gegenplatte ca. 2 ... 3 cm über der Einkoppelplatte (Anspruch 5). Diese Gegenplatte sammelt die Feldlinien und führt den Verschiebestrom zurück zum Generator, so daß keine Gleichtaktkomponente durch den Prüfling fließt. Die am Applizierende der Sonde befindliche Einkoppelplatte dient bei allen erfindungsgemäßen Feldsonden mit ihrer Unterseite zum Einkoppeln in den Prüfling.

Im Bereich des Griffstabes können die Verbindungsleitungen zur Unterdrückung der Gleichstromkomponente durch ein Ferritrohr geführt sein, s. Anspruch 7.

Generell können die Sonden in Größe, Art und Aufbau auswechselbar sein.

Die Sonde zur Erzeugung des pulsartigen elektrischen Feldes besteht beispielsweise aus einem metallischen Koppelplattenpaar, von deren Oberfläche das elektrische Feld ausgeht. Die Kapazität der als Kondensatorplatten wirkenden Koppelplatten bildet allein oder mit einer weiteren Kapazität den Ladekondensator C eines Störgenerators. In dem Fall, wo nur eine Platte vorhanden ist, ist eine zusätzliche Kapazität unverzichtbar.
Der Kondensator C wird von einer Spannungsquelle U über einen Vorwiderstand $R_V$ oder mittels eines Schaltreglers aufgeladen. Dabei kann der Schaltregler über einen einzigen Schaltvorgang oder über mehrere Schaltvorgänge den Kondensator aufladen.
Parallel zum Kondensator C, der durch das Plattenpaar in der Sonde gebildet wird, liegt eine Schaltstrecke. Die Schaltstrecke schaltet bei einer definierten Durchbruchsspannung, d.h. sie wird leitfähig.

Wenn die Spannung über dem Kondensator C im Verlauf des Ladevorganges die Durchbruchsspannung der Schaltstrecke erreicht, wird die Schaltstrecke kurzschlußartig leitfähig. Der Kondensator C entlädt sich schlagartig, wodurch die Kondensatorspannung zusammenbricht.
Da die Koppelplatten der Sonde den Kondensator C bilden, ist der Zeitverlauf des elektrischen Feldes in Plattennähe dem Zeitverlauf der Kondensatorspannung proportional. Es entsteht ein lokal konzentriertes pulsartiges elektrisches Feld.

Nach dem Durchbruch erlangt die Schaltstrecke ihre Sperrfähigkeit zurück und ein neuer Ladevorgang beginnt. Die beschriebenen Vorgänge wiederholen sich periodisch; das Gerät arbeitet mit einer konstanten Puls-Wiederholfrequenz. Der Ladekondensator kann auch auf eine Spannung, die kleiner ist als die Durchbruchsspannung der Schaltstrecke, aufgeladen werden. Die Entladung geschieht dann durch Triggerung einer triggerbaren Schaltstrecke.

Die Schaltung zur Erzeugung pulsartiger magnetischer Felder besitzt eine (Miniatur-)Induktionsspule. Eine Spannungsquelle U lädt über einen Vorwiderstand $R_V$ oder mittels eines Schaltreglers den Kondensator C. Parallel zum Kondensator C liegt die bereits beschriebene Schaltstrecke.
Wenn im Verlauf des Ladevorganges die Spannung über dem Kondensator C die Durchbruchsspannung der Schaltstrecke erreicht, kommt es zum Durchbruch, was einen pulsartigen Stromfluß zur Folge hat. Dabei entlädt sich der Kondensator C schlagartig über die Schaltstrecke und die in Reihe eingefügte Induktionsspule.
Der pulsartige Strom erzeugt in der Induktionsspule das für den Beeinflussungvorgang gewünschte pulsartige Magnetfeld. Der weitere Ablauf ist analog zur beschriebenen Schaltung zur Erzeugung pulsartiger elektrischer Felder.

Um die Intensität der von den Feldquellen abgegebenen Pulsfelder direkt an den über Kabel von einem Störimpulsgenerator gespeisten Sonden einstellbar zu machen, kann parallel in die Sondenleitung ein verstellbarer Widerstand geschaltet werden, der von außen veränderlich ist. Über diesen verstellbaren Widerstand wird für die Induktionsspule oder die Koppelplatten der Sonde eine Strom- bzw. Spannungsteilung erzeugt, s. Anspruch 8. Ein derartiger Regelwiderstand kann auch auf die Sonden aufgesteckt werden.

Für viele praktische Anwendungsfälle der erfindungsgemäßen Feldquellen ist die Einstellung einer zu den Raumverhältnissen des Untersuchungsobjektes adäquaten Feldgeometrie bzw. die Erzeugung der gewünschten Geometrie des Feldlinienverlaufs Erfolgsvoraussetzung.

Zur Bündelung des magnetischen Pulsfeldes am Sondenaustritt bzw. an der Abstrahlfläche der Sonde wird in die an der Sondenspitze befindliche Spule ein Ferritstab gesteckt, oder die Spule wird an der Stirnseite des Stabes angebracht, so daß das magnetische Feld von der Sondenstirnseite konzentriert in die untersuchten Schaltungen gelenkt wird, s. Anspruch 9. Der Ferritstab erstreckt sich dabei entlang der gedachten Längsachse in das Gehäuse der Feldquelle hinein.

Auf den Ferritstab kann höhenverstellbar zur Einstellung der Wirkungslänge eine an einem Umfangspunkt radial geschlitzte Metallscheibe aufgebracht werden.

Die beschriebenen Maßnahmen können auch kombiniert zum Einsatz kommen.

Die beschriebenen Lösungen zur B-Feldbündelung können mit einer Gleichtaktunterdrückung kombiniert werden, in dem nach Anspruch 10 die Verbindungsleitung zur Induktionsspule durch ein Ferritelement geführt wird. Die Spule schließt sich dabei an das Ferritelement an und liegt mit dem Ferritelement auf einer gemeinsamen Längsachse.

In analoger Weise kann auch die Leitungsverbindung zwischen Plattenpaar und Störimpulsgenerator zur Gleichtaktbedämpfung mit Ferritelementen versehen werden.

Zur selektiven Einkopplung von auf kleinstem Raum gebündelten, pulsartigen Magnetfeldern in besonders sensible Bereiche von elektronischen Geräten, Schaltkreisen und Bauelementen wurden erfindungsgemäß Magnetfeldsonden entwickelt, bei denen in einer ersten Version zwei Miniaturinduktionsspulen in Form einer Acht in der Sondenspitze angeordnet sind, s. Anspruch 11.

In einer zweiten Version handelt es sich um eine Miniatur-Magnetfeldsonde, die im Sondenkopf einen zur Sondenspitze hin offenen U-förmigen Magnetkern aufweist, auf den eine Miniaturinduktionsspule aufgebracht ist (Anspruch 12).

Kennzeichnendes Merkmal der Miniatursonden ist die Kleinheit des Sondenkopfes mit einem Kopfdurchmesser bis in den Millimeter- und Zehntelmillimeter-Bereich hinein. Dadurch kann zwischen den Leiterzügen, an einzelnen IC-Pins, an Spalten, Öffnungen in Masseflächen (Fenster), an Signalleiterschleifen IC-Ausgang zu IC-Eingang und niederohmigen Signalquellen, in Chipbereichen von IC usw. eingekoppelt werden.

Um das elektrische (Puls)Feld zu unterdrücken, das infolge der pulsartigen Spannungsdifferenz am Sondenkopf entsteht und den Prüfling ungewollt beeinflussen kann, soll die Sondenanordnung auf eine spezielle Art geschirmt werden.

Die Induktionsspule ist auf einen Ferritstab aufgebracht. Der Ferritstab kann einen Durchmesser von 0,2 bis 5 Millimeter aufweisen. Die Induktionsspule beginnt einige Millimeter hinter der feldabgebenden Stirnseite des Ferritstabes bzw. des Sondenkopfes. Die Anschlüsse der Spule führen zu einem Störgrößengenerator, der batteriebetrieben in der Sonde oder über Kabel extern verbunden ist. Der Ferritstab hat die Länge von einigen Zentimetern.

Der Schirm umhüllt bis auf einige spezielle Öffnungen die gesamte Sonde und setzt sich bis zum Störgrößengenerator fort, d.h. eine batteriebetriebene Stiftsonde erhält einen den Störgrößengenerator umfassenden Schirm, vgl. Anspruch 13.

Die Abschirmung ist bis an die Kante der feldabgebenden Seite des Ferritstabes geführt und überdeckt zur elektrischen Schirmung die Induktionsspule. Die Öffnung des Schirmes entspricht der Stirnseite des Ferritstabes und ist zugleich die Austrittsöffnung des pulsartigen Magnetfeldes.

Als Besonderheit kann die Schirmung im Bereich des Ferrites einen Längsschlitz besitzen, der im Bereich des sondeninneren Ferritstabendes erweitert sein kann. Am Sondenkopf endet der Schlitz in der Austrittsöffnung des Magnetfeldes. An dem gegenüber liegenden Schlitzbereich, der dem erweiterten Schlitzbereich entspricht, treten die magnetischen Feldlinien ein, die vom Ferritstab geführt aus dem Sondenkopf austreten, s. Anspruch 14.

Die Parameter der Störimpulsform des elektrischen oder des magnetischen Feldes können durch Einfügen von passiven R-, L-, C-Bauelementen in die Generatorschaltung verändert werden. Das heißt beispielsweise für die Schaltung zur Erzeugung pulsförmiger elektrischer Felder:

Ein zu den Koppelplatten bzw. zum Kondensator C in Reihe geschalteter Widerstand dient der Einstellung eines definierten Spannungs- bzw. E-Feld-Anstieges oder Abfalles. Analog verändert in der Schaltung zur Erzeugung pulsartiger magnetischer Felder ein zur Induktionsspule in Reihe liegender Widerstand die Parameter des Spulenstromes und somit des Magnetfeldes in definierter Art.

Anstelle des Widerstandes kann auch ein Transistor in Emitterschaltung verwendet werden.

Die Schaltstrecke kann aus einer Funkenstrecke oder einem Transistor bestehen (Anspruch 15). Die Funktion der Funkenstrecke kann dabei nach Anspruch 16 von einem edelgasgefüllten Überspannungsableiter übernommen werden.

Der Transistor wird im Durchbruchsbereich unter Nutzung des Avalancheeffektes betrieben.

Wenn ein Transistor als Schaltstrecke verwendet wird, kann die Impulsauslösung, d.h. die Auslösung der Schaltfunktion und damit die Pulswiederholfrequenz durch entsprechende Triggerung über die Basis des Transistors erfolgen, oder die Auslösung der Schaltfunktion wird durch Erhöhung der Schaltstreckenspannung über die Durchbruchspannung bewirkt. Die Pulswiederholfrequenz läßt sich dann mit dem Vorwiderstand $R_V$, der zwischen Spannungsquelle U und Ladekondensator C angeordnet ist, verstellen. Eine Wertveränderung des Vorwiderstandes $R_V$ verändert die Ladezeitkonstante, wodurch die Ladezeit, d.h. die Periodendauer bis zum Erreichen der Durchbruchspannung variiert werden kann.

Wenn der Ladekondensator über einen Schaltregler gespeist wird, ist das Erreichen der Durchbruchspannung von der Steuerung des Schaltreglers abhängig.

Beim Einsatz von vorzugsweise Bipolartransistoren wird der 2. Durchbruch eines Transistors ausgenutzt. Problematisch ist dabei, daß die Durchbrüche in ihrer Aufeinanderfolge (1. und 2. Durchbruch bei Spannungssteigerung) exemplarabhängig sind. Es kann z.B. bei Spannungserhöhung gleich der 2. Durchbruch ohne merklichen 1.

Durchbruch ausgelöst werden.

Eine technische Ausnutzung des Effektes wird dadurch behindert.

Erfindungsgemäß werden deshalb die Durchbrüche durch Beschaltungen gezielt gesteuert und der 2. Durchbruch unabhängig vom 1. Durchbruch definiert getriggert.

Die definierte Erzeugung des 1. oder des 2. Durchbruchs ist die Voraussetzung für die definierte Steuerbarkeit der Transistoren und deren Verwendbarkeit als Schaltstrecke für den Störimpulsgenerator.

Nachfolgend wird eine Schaltung zur definierten Erzeugung des 1. Durchbruches beschrieben (Anspruch 17).

Die Schaltung soll einen stabilen 1. Durchbruch erzeugen und einen 2. Durchbruch verhindern; Ausgangspunkt ist die Emitterschaltung.

Zwischen Basis und Emitter wird ein niederohmiges Bauelement, beispielsweise eine Spannungsquelle, geschaltet. Insbesondere muß der Wechselstromwiderstand niederohmig sein.

Die Spannung dieser Spannungsquelle kann zwischen negativen Werten, Null und der Flußspannung der Basis-Emitterdiode des Transistors liegen. Mit der Spannung der Spannungsquelle ist der 1. Durchbruch steuerbar.

Die erfindungsgemäßen Schaltungen zur definierten Erzeugung des 2. Durchbruches sollen bei einer definierten Kollektor-Emitterspannung einmal einen stabil einsetzenden 2. Durchbruch und zum anderen einen triggerbaren 2. Durchbruch herbeiführen.

Für die Erzeugung eines stabilen 2. Durchbruchs wird dabei nach Anspruch 18 die Basis des Transistors mit einem für Wechselstrom hochohmigen Widerstand beschaltet.

Der Wechselstromwiderstand kann aus einem ohmschen Widerstand und/oder aus einer Induktivität bestehen.

Mit dieser Schaltung geht der Transistor bei Erhöhung der Kollektor-Emitterspannung auf die Durchbruchspannung direkt in den 2. Durchbruch über.

Zur Triggerung des zweiten Durchbruchs nach Anspruch 19 wird in die Basis des Transistors (über einen Triggerschalter) ein Strom einer hochohmigen Stromquelle eingespeist. Die Stromquelle muß im wesentlichen einen für Wechselstrom hochohmigen Innenwiderstand besitzen.

Der durch Schließen des Schalters eingespeiste Strom zündet bei entsprechender Spannung den 2. Durchbruch.

Eine weitere Prinzipschaltung zur Erzeugung eines stabilen 1. Durchbruchs und zur Triggerung des 2. Durchbruchs zeichnet sich nach Anspruch 20 bis 22 dadurch aus, daß der Transistor durch ein für Wechselspannung und Gleichspannung niederohmiges Bauelement, beispielsweise eine Spannungsquelle, bei ausreichender Kollektor-Emitterspannung im 1. Durchbruch gehalten wird.

Wenn der Triggerschalter umschaltet, wird die niederohmige Spannungsquelle von der Basis getrennt und eine hochohmige Stromquelle an die Basis geschaltet.

Der damit in die Basis einfließende Strom triggert den 2. Durchbruch.

Durch Kaskadierung von zwei oder mehreren Transistoren für den Durchbruchbetrieb (1. und 2. Durchbruch) gemäß Anspruch 23 kann der Arbeitsbereich der Schaltstrecke auf einen größeren Spannungsbereich ausgedehnt werden. Auf diese Weise können auch höhere Spannungen geschaltet werden.

Der zweite Durchbruch des ersten Transistors wird mittels der beschriebenen Beschaltungen der Transistorbasis bewirkt. Dabei kann die Initialisierung des Durchbruchs durch Triggerung der Basis oder durch Erhöhung der Kollektor-Emitter-Spannung bis auf die Durchbruchsspannung erfolgen. Dieses Zünden des ersten Transistors bewirkt eine Erhöhung der Kollektor-Emitter-Spannung am zweiten Transistor, der dann durch Überschreiten der Kollektor-Emitter-Durchbruchsspannung zündet.

Eine weitere Schaltung zur Erzeugung von Störspannungsimpulsen hoher Spannung besteht aus einem Stoßspannungsgenerator mit Kondensatorkaskade, bei denen die Schaltstrecken von Transistoren im Durchbruchbetrieb gebildet werden.

In vorteilhafter Anwendung der beschriebenen Erfindung kann mit einem faserschreibergroßen Gerät, das alle Komponenten (Burst-/ESD-Generator, spezielle Sondenanordnung mit austauschbaren Sondenköpfen zur Erzeugung der pulsartigen E- und B-Felder, ggf. Batterie, Bedienelemente wie Ein- und Ausschalter, Intensitätsverstellung, Vorwahl für Einzelimpulse oder Impulsfolgen, Ladeanzeige für Batterie, Polaritätsumschaltung des Störfeldes) enthält, die bisher nur einzeln zur Verfügung standen und für den Meßvorgang zu koppeln waren, auf kleinstem Raum ein pulsartiges elektrisches oder magnetisches Feld extrem hoher Flankensteilheit (ca. 1 ns) und Intensität (einige Millitesla bzw. ca. Tausend Volt pro Millimeter) in die zu untersuchende - Schaltung eingekoppelt werden.

Weitere Einzelheiten, Merkmale und Vorteile der Erfindung ergeben sich aus der nachfolgenden Beschreibung von Ausführungsbeispielen unter Bezugnahme auf die zugehörige Zeichnung. Es zeigen

Fig. 1     zwei Ausführungsformen für ein netzunabhängiges, stiftartiges Gerät zur Erzeugung lokaler, pulsarmiger magnetischer und/oder elektrischer Felder,

Fig. 2 eine Sonde zur Abgabe eines pulsartigen elektrischen Feldes mit einem Applikator in Scheibenform,

Fig. 3 die Schaltung zur Einstellung der Intensität der Feldquelle an der Sonde,

Fig. 4 eine Sonde zur Bündelung des elektrischen Feldes an der Abstrahlfläche,

Fig. 5 die Schnittdarstellung einer E-Feldsonde mit zwei parallelen Koppelplatten,

Fig. 6 die Prinzipdarstellung einer E-Feldsonde mit Einkoppelplatte und separater Gegenplatte,

Fig. 7 die Gesamtansicht einer E-Feldsonde mit einer isolierten Koppelplatte,

Fig. 8 die Anordnung eines Ferritelements zur B-Feld-Bündelung und gleichzeitigen Gleichtaktunterdrückung,

Fig. 9 Sonden zur Bündelung des magnetischen Feldes an der Abstrahlfläche,

Fig. 10 Magnetfeldsonde mit einer Miniaturinduktionsspule,

Fig. 11 Magnetfeldsonde mit zwei Miniaturinduktionsspulen,

Fig. 12 Magnetfeldsonde mit in den Sondenkopf eingebrachtem U-förmigen Magnetkern und aufsitzender Miniaturinduktionsspule,

Fig. 13 den prinzipiellen Aufbau der Feldsonde mit Induktionsspule, Ferritstab und Schirmung,

Fig. 14 ein spezielle Ausführungsform nach Fig. 9, bei der die Schirmung einen Längsschlitz aufweist,

Fig. 15 Schaltungsbeispiele für Feldquellen zur Erzeugung pulsartiger elektrischer Felder,

Fig. 16 Schaltungsbeispiele für Feldquellen zur Erzeugung pulsartiger magnetischer Felder,

Fig. 17 Grundschaltung und Realisierungsbeispiel für eine Schaltung zur definierten Herbeiführung des 1. Durchbruchs,

Fig. 18 Schaltung zur Erzeugung eines stabilen 2. Durchbruchs,

Fig. 19 Prinzipschaltung und Schaltungsbeispiel zur Triggerung des 2. Durchbruchs,

Fig. 20 Prinzipschaltung und zwei Schaltungsbeispiele zur Erzeugung eines stabilen 1. Durchbruchs und zur Triggerung des 2. Durchbruchs,

Fig. 21 zwei Schaltungen zur Kaskadierung von zwei Transistoren für den Durchbruchbetrieb.

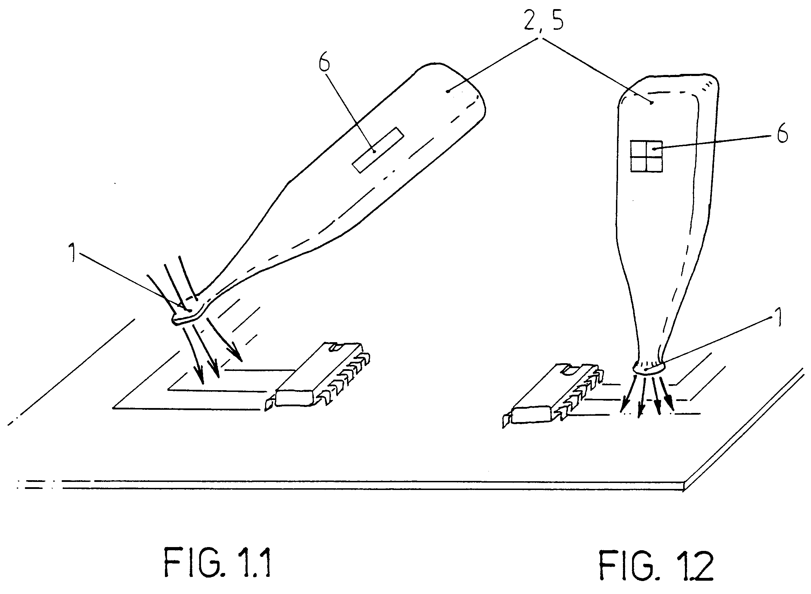

Die erfindungsgemäßen Feldquellen für ein lokales pulsförmiges elektrisches bzw. magnetisches Feld bestehen aus einem kompakten Gerät, s. Fig. 1, in dem Sonde 1, Störimpulsgenerator 2 und ggf. Spannungsquelle 5 zusammengefaßt sind.

Fig. 1 zeigt zwei Ausführungsformen der Feldquelle, wobei das Gerät stiftartig ausgebildet ist und neben der Sonde 1 alle Grundelemente, wie Störimpulsgenerator 2, Spannungsquelle 5 und Bedienelemente 6 für die Parametereinstellung enthält. Das Gerät kann von einer Hand wie ein Schreibgerät aufgenommen werden.

Mit den Ausführungsformen nach Fig. 1.1 und 1.2 wird die Sondenausbildung in zwei typischen Applikatorformen gezeigt.

Die Applikatorform nach Fig. 1.1 steht dabei für eine Sonde 1 zur Erzeugung lokaler pulsförmiger elektrischer Felder. Das als Sonde dienende Plattenpaar ist hier kompakt übereinander in der Prüfspitze angeordnet, wobei die Außenflächen des Plattenpaares im Sinne eines elektrischen Felddipols das elektrische Feld abgeben.

Die Applikatorform der Feldquelle nach Fig. 1.2 beinhaltet eine Sonde 1 zur Erzeugung pulsartiger magnetischer Felder.

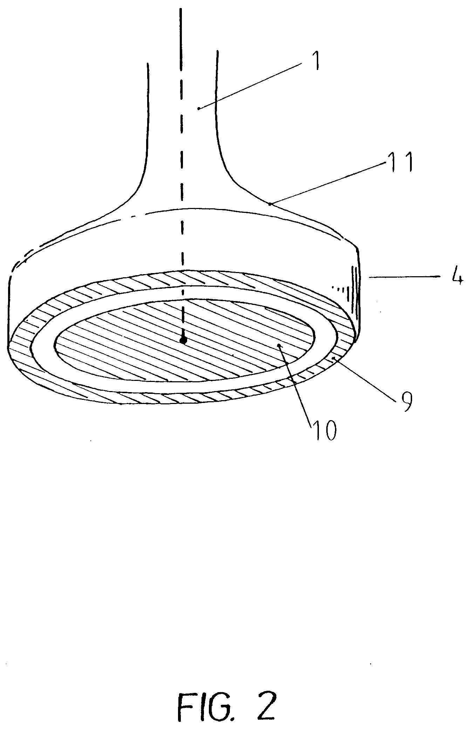

In Fig. 2 ist ein Applikator zur Abgabe eines pulsartigen elektrischen Feldes in Scheibenform dargestellt. die beiden Koppelplatten 4 sind hier einmal als äußere Ringelektrode 9 und zum anderen als von der Ringelektrode eingeschlossene Scheibenelektrode 10 ausgeführt. In der hier gezeigten Ausführungsform mit scheibenförmiger Ausbildung der Sondenspitze 1 setzt sich die ringförmige Außenelektrode 9 über die nachfolgend verjüngte Sonde als Abschirmung 11 fort.

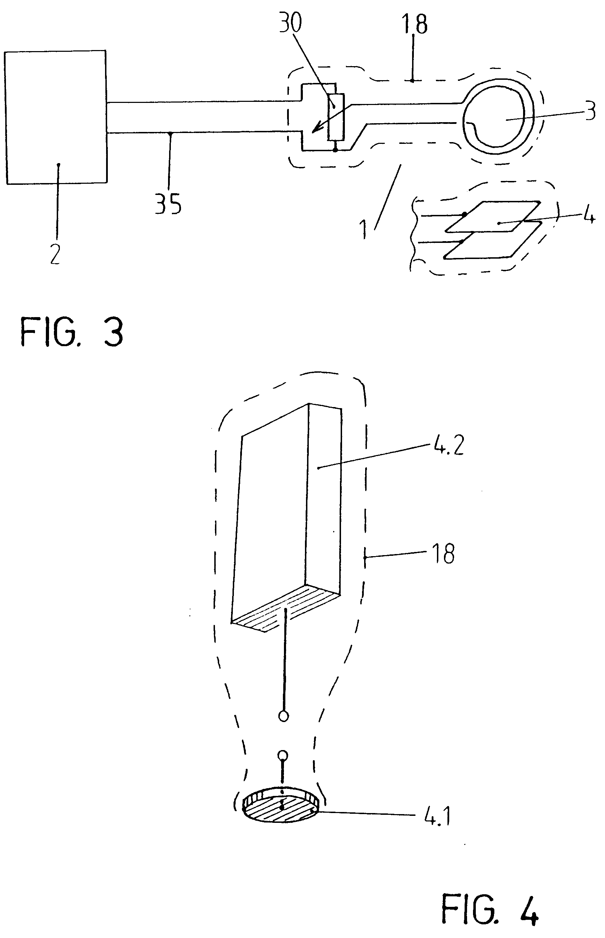

Fig. 3 zeigt die Schaltung zur Einstellung der Intensität der Feldquelle zur Erzeugung pulsartiger B- bzw. E-Felder an der Sonde.

Ein Störimpulsgenerator 2 ist über ein Verbindungskabel 35 mit der Sonde 1 verbunden. Im Gehäuse 18 der Sonde 1 integriert ist die Induktionsspule 3 oder das Plattenpaar 4 sowie ein parallel in die Sondenleitung eingeschaltetes Potentiometer 30.

Bei der Anordnung nach Fig. 4 wird die Funktion der inneren Koppelplatte bzw. der Gegenplatte zur in der Sondenspitze befindlichen Platte 4.1 von den im Geräteinneren der Feldquelle vorhandenen Metallteilen wahrgenommen.

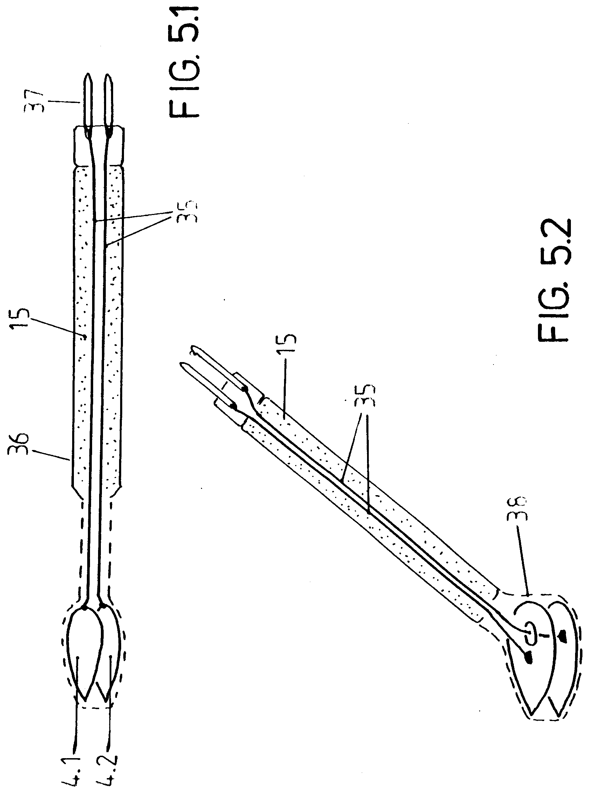

Die E-Feldsonde nach Fig. 5 besitzt zwei parallele Koppelplatten 4.1, 4.2, die von einem Burstgenerator über Steckverbinder 37 mit Störstrom bzw. Störspannung gespeist werden. Sie erzeugen an ihrer Oberfläche gebündelte, pulsartige, elektrische Felder. Diese können, entsprechend der Sondengröße, partiell in die Leiterzugstrukturen und IC von Leiterkarten eingespeist werden.

Das Plattenpaar 4.1, 4.2 ist mit dem Griffstab 36 starr verbunden. Bei der Sonde nach Fig. 5.1 liegt der Griffstab 36 in der Ebene der Platten; bei der Sonde nach Fig. 5.2 steht die Ebene der Platten in einem Winkel von ca. 70° zum Griffstab. Die Größe des Plattenpaares beträgt etwa 1 cm.

Im Bereich des Griffstabes sind die Verbindungsleitungen 35 durch ein Ferritrohr 15 geführt. Die Verbindungsleitungen 35 besitzen eine elektrische Isolation 38.

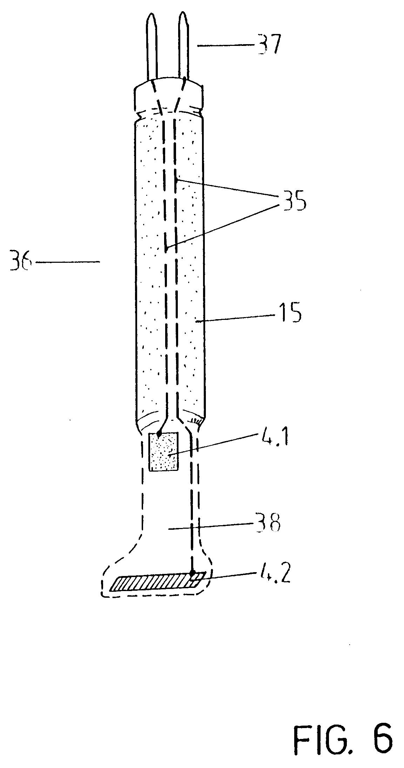

Bei der E-Feldsonde nach Fig. 6 handelt es sich um eine spezielle Ausführung, bei der die am Applizierenden der Sonde befindliche Einkoppelplatte 4.2 einen Winkel von etwa 90° zum Griffstab 36 aufweist. Die rechteckförmige Gegenplatte 4.1 befindet sich in etwa senkrechter Anordnung ca. 3 cm über der Einkoppelplatte 4.2.

Die Einkoppelplatte ist beispielsweise streifenförmig in den Abmessungen 1 mm × 8 mm ausgeführt; sie kann auch eine Lanzettenform besitzen.

Die Gegenplatte 4.1 nimmt die von der Einkoppelplatte 4.2 in den Prüfling (beispielsweise Leiterzug) eingekoppelten Feldlinien auf und führt den Verschiebestrom zurück zum Generator. Dieser Effekt wird durch das Ferritrohr 15 unterstützt.

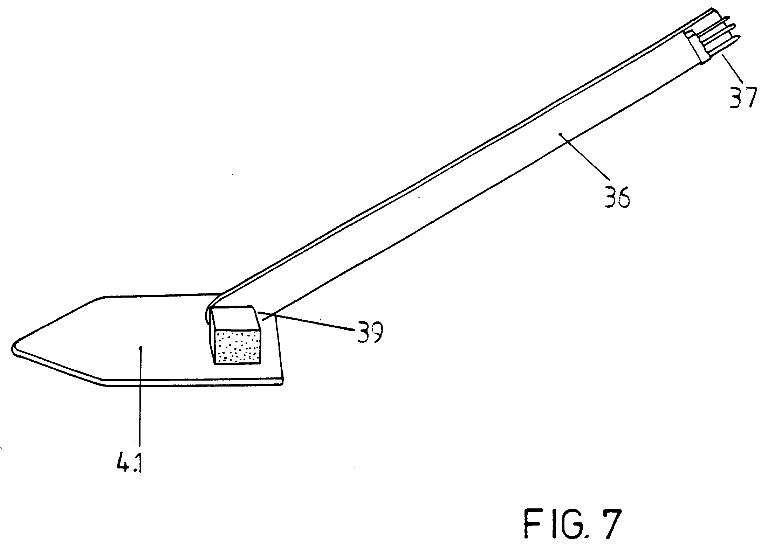

Die E-Feldsonde nach Fig. 7 besteht aus einer isolierten Koppelplatte 4.1, die von einem Impulsdichtegenerator mit Störstrom bzw. Störspannung gespeist werden kann. Sie erzeugt an ihrer Oberfläche gebündelte pulsartige elektrische Felder hoher Flankensteilheit und ist zur Bewertung größerer Flächen geeignet (einige cm$^2$, z.B. Bussysteme).

Die Anwendung erfolgt im Rahmen entwicklungsbegleitender Untersuchungen zur Fremdstörfestigkeit. Auf Leiterkarten oder in Gerätekonstruktionen sind ESD- bzw. Burst-Schwachstellen aufspürbar.

Mit der Fläche der Sonde können elektrische Felder simuliert werden, die z.B. bei ESD-Entladungen von Metallflächen (Gehäusewände oder Konstruktionsteile) ausgehen.

Die Spitze der Sonde eignet sich zur lokalen Schwachstellensuche, dem Aufspüren von empfindlichen Bauelementen und Leitungen.

Zur Störstromeinspeisung können parasitäre Kapazitäten simuliert werden.

Die Koppelplatte ist zur besseren Handhabung schwenkbar mittels Gelenk oder einem flexiblen Verbindungsstück 39 am Griff 36 befestigt.

Die Koppelplatte 4.1 hat bei diesem Ausführungsbeispiel eine Größe von ca. 20 × 60 mm mit ausgeprägter Spitze.

Diese E-Feldsonde besitzt einen einpoligen Anschluß 37, der einen Gleichtaktbetrieb ermöglicht. Der Gegenpol des Generators kann an den Prüfling oder an eine separate Fläche angeschlossen werden oder frei bleiben.

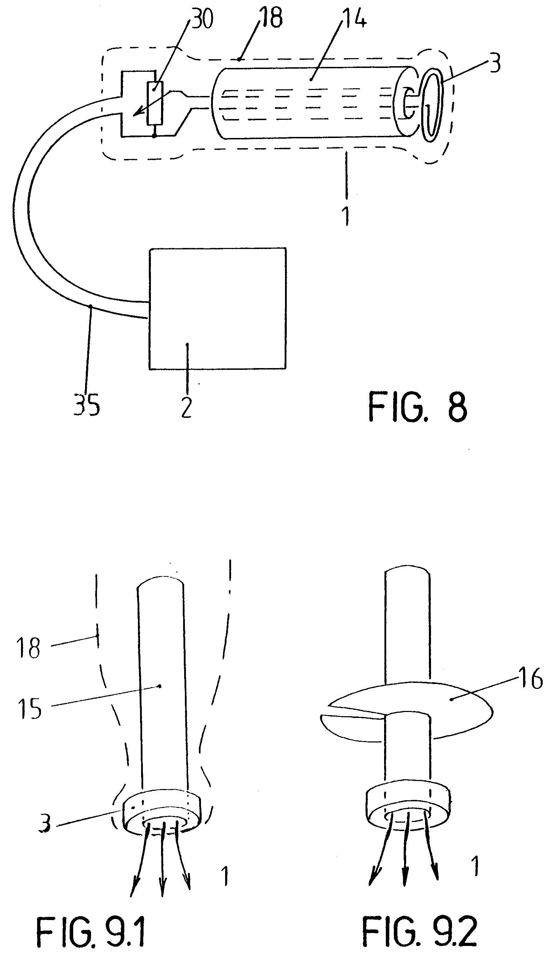

In Fig. 8 ist eine komplette Sonde 1 zur B-Felderzeugung dargestellt. Sie besitzt eine Intensitätsverstellmöglichkeit in Form eines Potentiometers 30 kombiniert mit einem Ferritelement 14 zur B-Feldbündelung und gleichzeitigen Gleichtaktunterdrückung.

Von einem Störimpulsgenerator 2 wird pulsartiger Störstrom über ein Verbindungskabel 35 in die Sonde 1 eingespeist. Am Eingang der Sonde befindet sich ein parallel liegender Widerstand 30 (Potentiometer). Der über einen Einstellknopf verstellbare Schleifer des Potentiometers greift eine Teilspannung bzw. einen Teilstrom für die Induktionsspule 3 ab.

Die Verbindungsleitung zwischen Potentiometer 30 und Induktionsspule 3 ist durch ein Ferritelement 14 geführt. Es dient der Gleichtaktunterdrückung und gleichzeitig der Feldbündelung.

Die Verbindung zwischen Sonde 1 und Einstellregler 30 sowie zwischen Einstellregler und Verbindungskabel 35 kann dabei über Steckverbinder erfolgen.

In Fig. 9 sind weitere Ausführungsformen für Spulen 3 bzw. Sonden 1 zur Bündelung des magnetischen Feldes an der Abstrahlfläche der Sonde dargestellt.

Bei der Anordnung nach Fig. 9.1 ist in die an der Sondenspitze befindliche Induktionsspule 3 ein Ferritstab 15 eingeschoben, der sich innerhalb des Gehäuses 18 der Feldquelle befindet.

Fig. 9.2 zeigt die Anordnung nach Fig. 9.1 mit zusätzlich aufgeschobener radial geschlitzter Metallscheibe 16.

Die Metallscheibe ist über die axiale Länge des Ferritstabes 15 höhenverstellbar angeordnet, wodurch die Feldgeometrie beeinflußt werden kann.

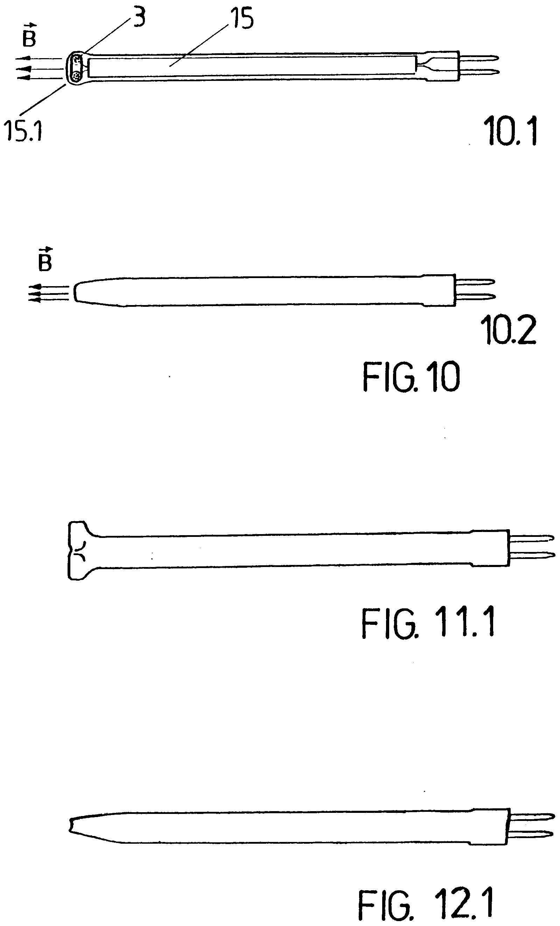

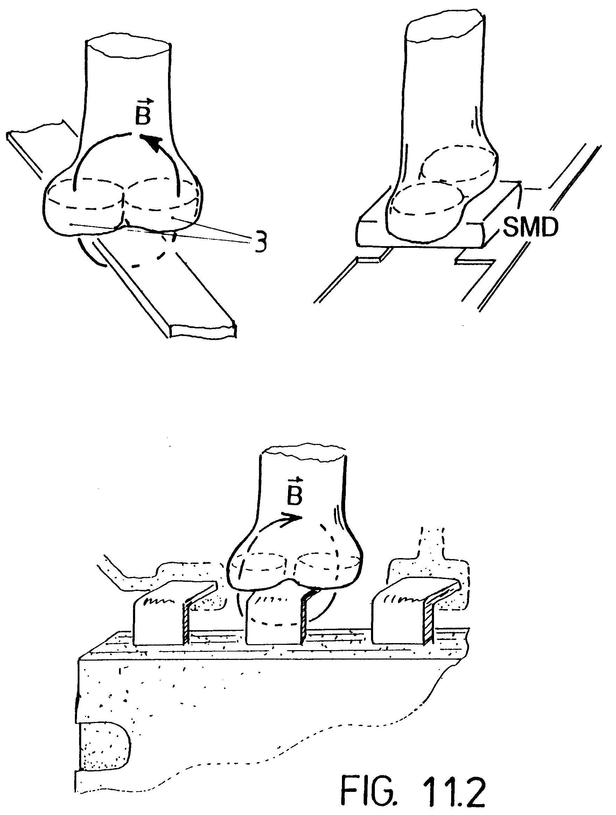

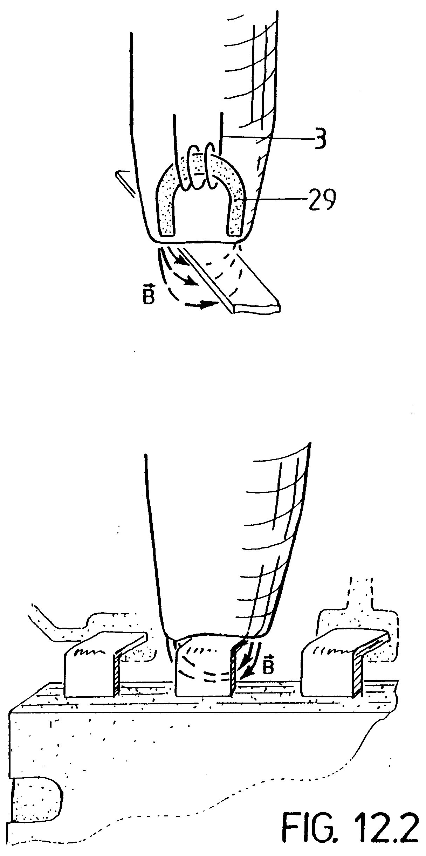

Die Figuren 10, 11.1 und 12.1 zeigen jeweils die Gesamtansicht der Magnetfeldsonden, die eine Baulänge von etwa 85 mm aufweisen.

Die Sonden nach Fig. 10 bestehen aus einer Miniaturinduktionsspule 3, die von einem Burstgenerator mit Störstrom gespeist wird. Sie erzeugt gebündelte, pulsartige Magnetfelder. Diese können, entsprechend der Sondengröße, partiell zwischen einzelne Leiterzüge von Leiterkarten oder Pin- und Chipbereiche von IC eingespeist werden.

Beide Sonden nach Fig. 10 besitzen als Besonderheit eine spezielle Feldbündelung, die es erlaubt, Schwachstellen in der Fremdstörfestigkeit von Leiterkarten, IC und beliebigen Verdrahtungen mit hoher Selektivität aufzuspüren bzw. zu erfassen. An der Stirnseite wird ein scharf gebündeltes, strahlförmiges Magnetfeld hoher Intensität abgegeben.

Bei der Sonde nach Fig. 10.1 ist auf der Spulenzuleitung ein Ferritrohr 15 aufgeschoben; diese Ferritrohr dient der Bündelung des von der Spule erzeugten Magnetfeldes und der Gleichtaktstromdämpfung der Spulenzuleitung.

Die Stirnseiten 15.1 der Sonden weisen einen Durchmesser von ca. 3,5 mm (Fig. 10.1) und ca. 2 mm (Fig. 10.2) auf.

Die Magnetfeldsonden nach Fig. 11 bestehen aus zwei in Form einer Acht angeordneten Miniaturinduktionsspulen 3, die von einem Burstgenerator mit Störstrom gespeist werden können. Die Spulen erzeugen kreisförmige, auf kleinem Raum gebündelte pulsartige Magnetfelder. Diese können sich selektiv um einzelne Leiterzüge, Leitungen, Anschlußdrähte, IC-Pins oder Bauelemente (SMD) ausbilden. Nur in dem ausgewählten Leiter wird eine Störspannung induziert, benachbarte Bereiche werden nur unwesentlich belastet.

Auf diese Weise können störempfindliche Anschlüsse und Signalwege ermittelt werden. Es sind störempfindliche Eingänge von IC und deren Signalverbindungen über Bauelemente hinweg sondierbar.

Bei der in Fig. 12 gezeigten Magnetfeldsonde sind im Sondenkopf ein zur Sondenspitze offener U-förmiger Magnetkern 29 in der Ausführung als aufgeschnittener, ursprünglich ringförmiger Ferritkern mit aufgebrachter Miniaturinduktionsspule 3 angeordnet.

Diese Sonde besitzt als Besonderheit eine spezielle Feldbündelung; im Millimeterbereich wird ein kreisförmiges, scharf gebündeltes Magnetfeld hoher Intensität erzeugt.

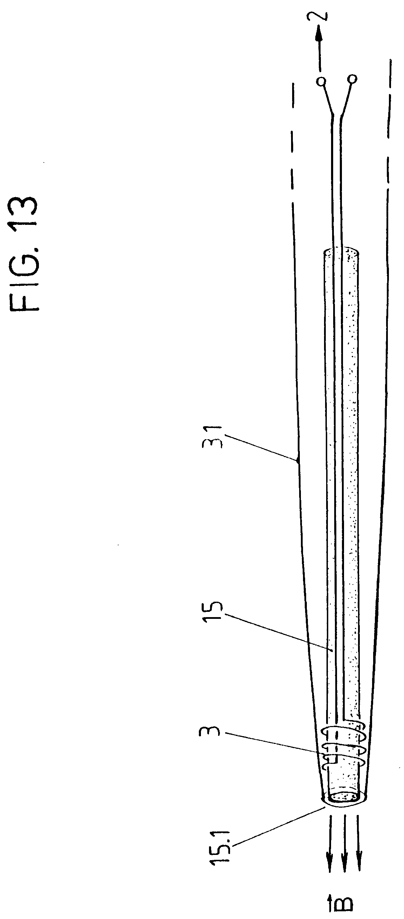

Fig. 13 zeigt den prinzipiellen Aufbau der B-Feldsonde mit Induktionsspule 3, die auf einem Ferritstab 15 aufsitzt. Der Abstand der Induktionsspule 3 von der feldabgebenden Stirnseite 15.1 der Feldsonde beträgt etwa 6 mm. Die Spulenanschlüsse führen zu einem Störgrößengenerator 2.

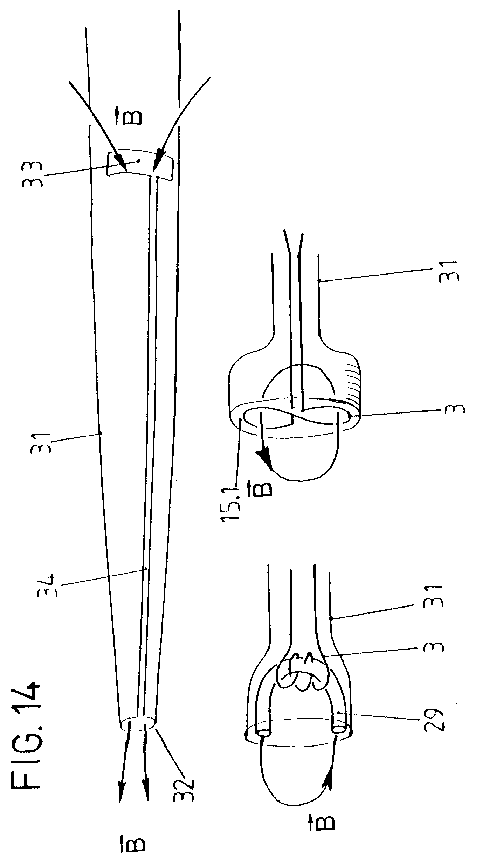

Die Sonde wird, ausgenommen die Stirnseite 15.1 als Austrittsöffnung des Magnetfeldes und der erweiterte Schlitz 33 im hinteren Teil der Sonde (s. Fig. 14) als Eintrittsöffnung des Magnetfeldes, vom Schirm 31 umhüllt. Bei der speziellen Ausführung der Schirmungsmaßnahme nach Fig. 14 ist in die Schirmung zwischen der feldabgebenden Stirnseite 15.1 und dem erweiterten Schlitz 33 ein Längsschlitz 34 vorhanden.

Als Sondenköpfe können mittels geschirmter Steckverbinder auch geschirmte Wechselsondenköpfe beispielsweise ein U-förmiges Ferritelement nach Fig. 12.2 oder eine achtförmige Induktionsspule nach Fig. 11.2 eingesetzt werden.

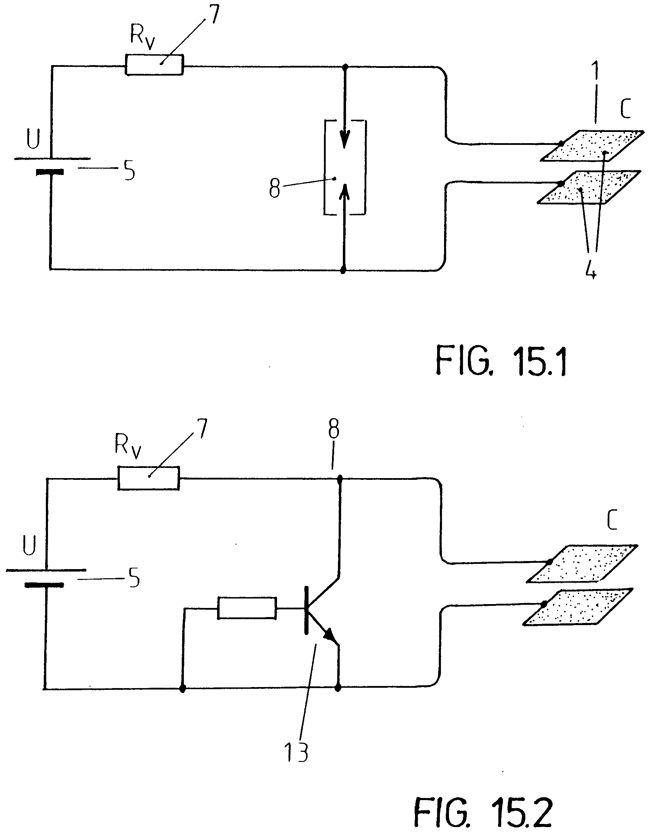

Fig. 15 demonstriert zwei Schaltungsbeispiele für Feldquellen zur Erzeugung pulsartiger elektrischer Felder.

In der Schaltung nach Fig. 15.1 arbeitet eine Generatorschaltung, bestehend aus Spannungsquelle 5, Vorwiderstand 7 und Schaltstrecke 8, auf die aus Koppelplatten 4 aufgebaute Sonde 1.

Die Koppelplatten 4 bilden den Ladekondensator C des Störgenerators. Die Schaltstrecke 8 liegt parallel zum Kondensator C und wird hier durch eine Funkenstrecke realisiert.

In Fig. 15.2 wird die Schaltfunktion der Schaltstrecke 8 durch einen Transistor 13 ausgeübt, der im Durchbruchsbereich unter Nutzung des Avalancheeffektes arbeitet.

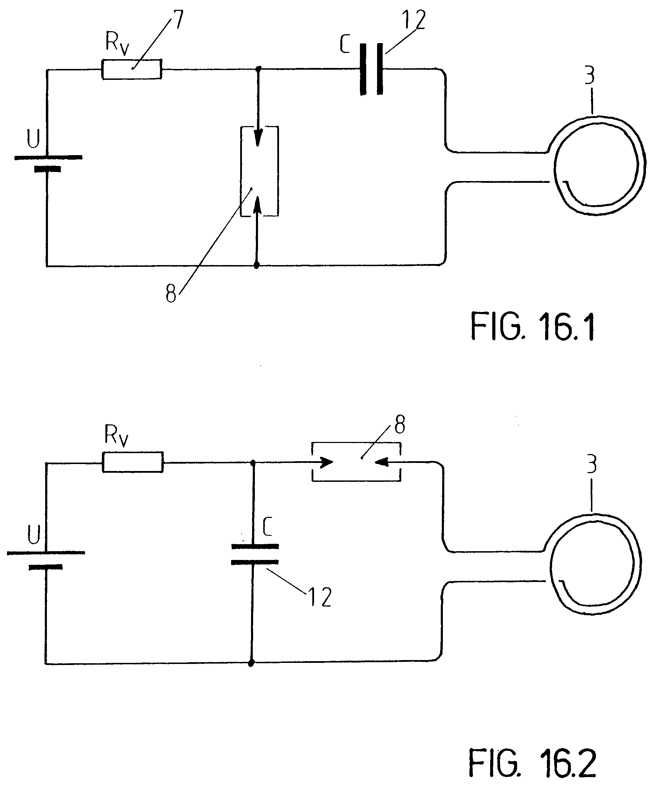

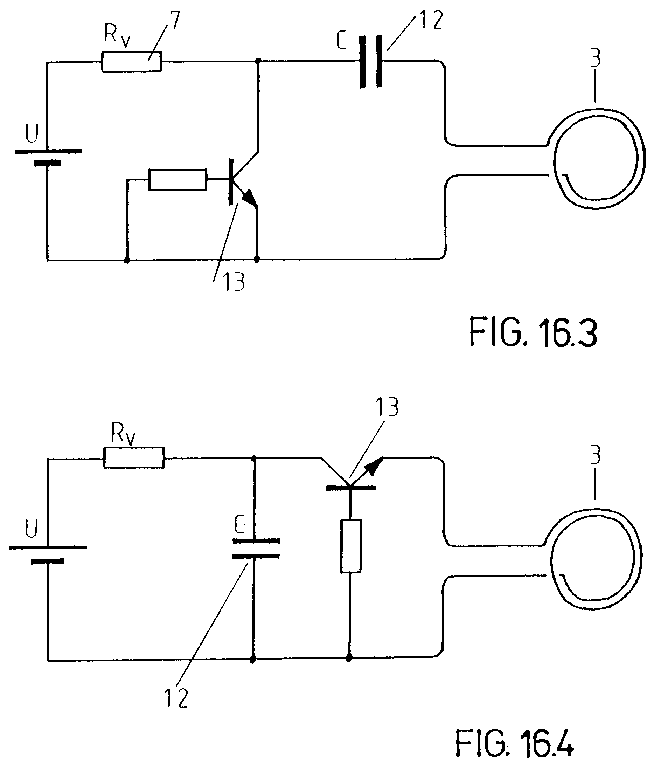

Die Schaltungsbeispiele in Fig. 16 betreffen Feldquellen zur Erzeugung pulsförmiger magnetischer Felder.

Die Spannungsquelle 5 lädt in Fig. 16.1 über einen Vorwiderstand den Kondensator 12 auf. Parallel zum Kondensator 12 liegt die Schaltstrecke 8, die in gleicher Weise wie bei der Erzeugung pulsförmiger elektrischer Felder aufgebaut ist. Nach Erreichen der Durchbruchsspannung der Schaltstrecke 8 entlädt sich der Kondensator 12 schlagartig über die im Kurzschlußkreis mit der Schaltstrecke 8 in Reihe liegende Induktionsspule 3.

In Fig. 16.2 sind lediglich die Anordnung von Schaltstrecke 8 und Kondensator 12 vertauscht.

Die Fig. 16.3 und 16.4 veranschaulichen die analogen Anordnungen, wobei anstelle der Funkenstrecke 8, jeweils ein Schalttransistor 13 eingefügt ist.

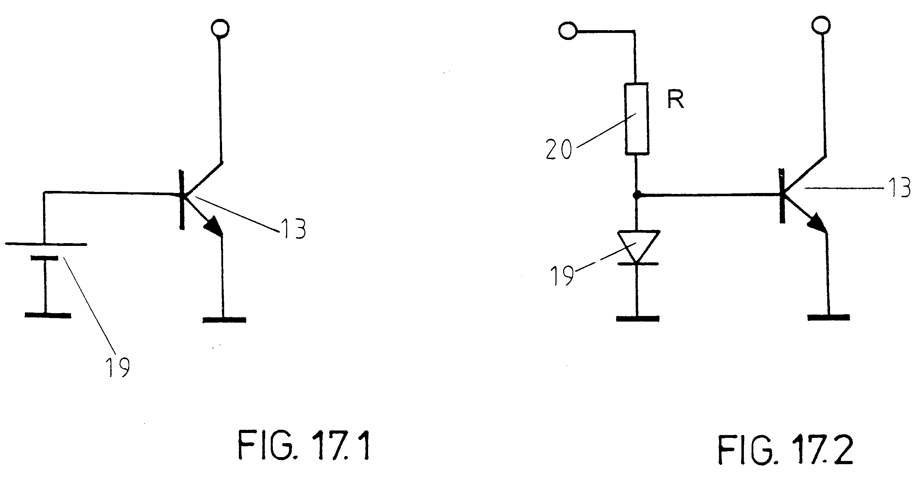

In Fig. 17 ist die Grundschaltung (Fig. 17.1) und ein Schaltungsbeispiel (Fig. 17.2) zur definierten Herbeiführung des 1. Durchbruchs beim Transistor 13 dargestellt.

Die Grundschaltung ist dadurch gekennzeichnet, daß zwischen Basis und Emitter als niederohmiges Bauelement eine Spannungsquelle 19 vorgesehen ist.

Beim Schaltungsbeispiel nach Fig. 17.2 dient als niederohmige Spannungsquelle 19 eine in Flußrichtung vorgespannte Diode. Die Vorspannung kann durch einen separaten Widerstand (R) 20 und/oder den aus der Basis ausfließenden Durchbruchstrom erzeugt werden. Der separate Widerstand 20 liegt an einer Hilfsspannung $V_{cc}$.

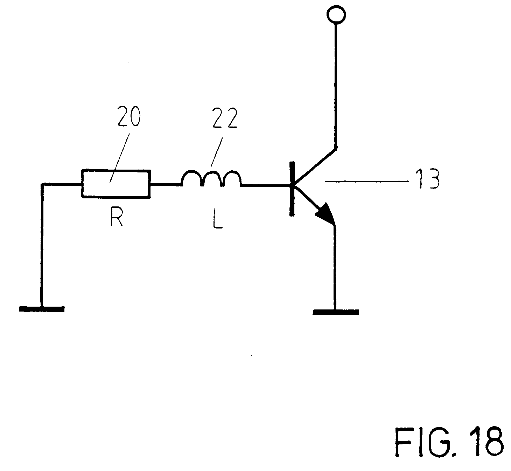

Fig. 18 zeigt die Prinzipschaltung zur Erzeugung eines stabilen 2. Durchbruchs. Die Basis des Transistors 13 ist mit einem für Wechselstrom hochohmigen Widerstand R, L, bestehend aus ohmschen Widerstand 20 und induktiven Widerstand 22, beschaltet.

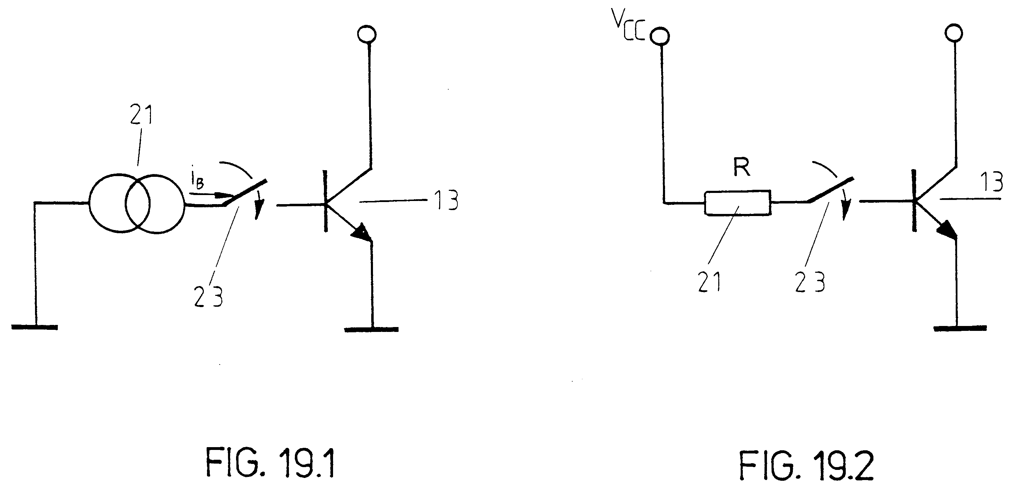

In Fig. 19.1 ist die Grundschaltung zur Triggerung des zweiten Durchbruchs dargestellt. Dabei wird in die Basis des Transistors 13 über einen Triggerschalter 23 ein Strom is einer hochohmigen Stromquelle 21 eingespeist.

In das Schaltungsbeispiel nach Fig. 19.2 wird als Stromquelle 21 ein an einer Hilfsspannung $V_{cc}$ liegender Widerstand R benutzt, der über einen Triggerschalter 23 an der Basis des Transistors 13 liegt.

Der durch Schließen des Schalters eingespeiste Strom zündet bei entsprechender Spannung den 2. Durchbruch.

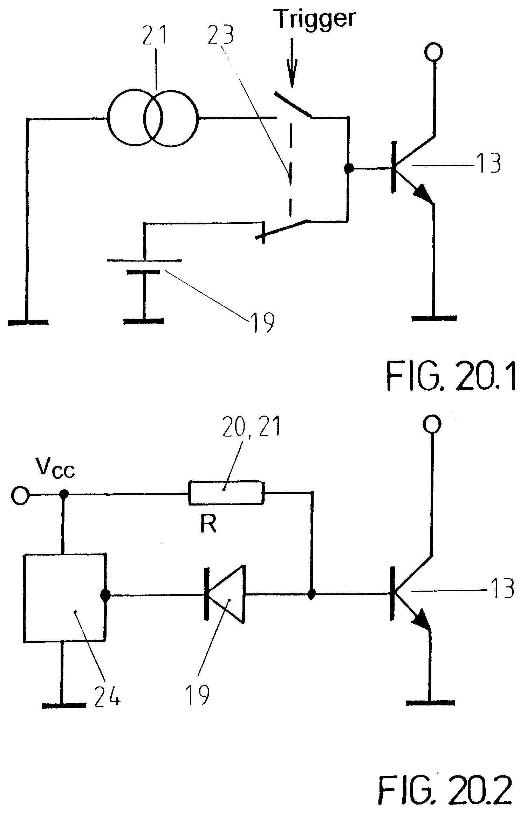

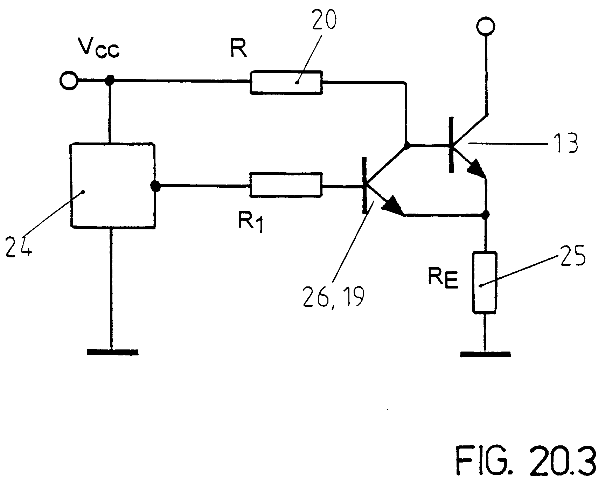

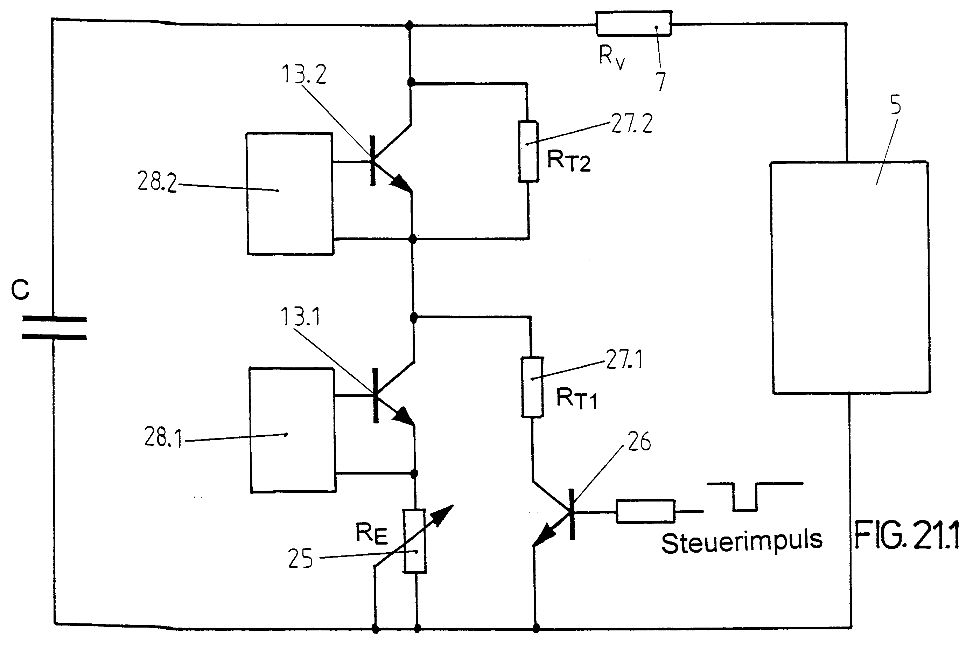

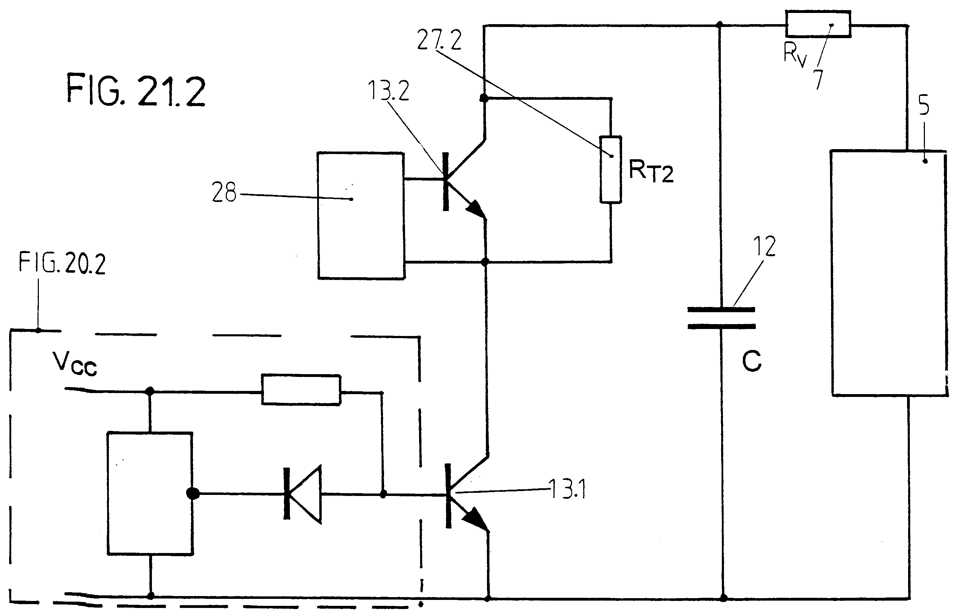

In der Prinzipschaltung nach Fig. 20.1 wird der Transistor 13 durch eine niederohmige Spannungsquelle 19 bei ausreichender Kollektor-Emitterspannung im 1. Durchbruch gehalten (in Fig. 20.1 gezeigte Schaltstellung).

Bei Umschalten des Triggerschalters 23 wird die Spannungsquelle 19 von der Transistorbasis getrennt und eine Stromquelle 21 an die Basis geschaltet. Diese Stromquelle ist für Gleich- und hauptsächlich für Wechselspannung hochohmig.

Der über diesen Zweig der Schaltung auf die Basis des Transistors 13 zugeschaltete Strom triggert den 2. Durchbruch.

Ein erstes Schaltungsbeipiel zeigt Fig. 20.2.; Aufbau und Funktionsweise dieser Schaltung können wie folgt beschrieben werden.

Im ersten Schaltzustand liegt der Gatterausgang des Gatters 24 auf Low-Pegel (L); die Schaltstrecke ist bei Erreichen des 1. Durchbruchs gesperrt. Die Diode wirkt als niederohmige Spannungsquelle 19 mit niedrigem Innenwiderstand an der Basis des Transistors 13.

Der Diodenstrom fließt aus der Basis oder über den Widerstand 20 in den auf "L" liegenden Gatterausgang. Die Flußspannung der Diode ist die Spannung der Spannungsquelle 19.

Der Transistor 13 wird durch den geringen Wechselstromwiderstand der Diode und des zugehörigen auf Low liegenden Gatterausgangs im 1. Durchbruch gehalten. Am Kollektor stabilisiert sich die Durchbruchspannung des 1. Durchbruchs.

Schaltet der Gatterausgang auf High-Pegel (H) (die Schaltstrecke geht vom 1. in den 2. Durchbruch über), wird die Diode 19 gesperrt, d.h. die Konstantspannung (Flußspannung) mit niedrigem Innenwiderstand wird unterbrochen. Die hochohmige Stromquelle 21, die durch den an der Hilfsspannung $V_{cc}$ liegenden Widerstand 20 gebildet wird, speist einen (Trigger)Strom in die Basis des Transistors 13 ein.

Durch die Hochohmigkeit und den Triggerstrom der Basis wird der 2. Durchbruch gezündet.

Das Schaltungsbeispiel nach Fig. 20.3 arbeitet mit einem Emitterwiderstand 25. Der Emitterwiderstand ($R_E$) 25 kann in den Stromkreis der Schaltstrecke 13 eingefügt werden, um die Parameter des zeitlichen Ablaufes des Schaltvorganges zu verändern (z.B. kann auf diese Weise die Entladezeitkonstante des Ladekondensators des Störimpulsgenerators beeinflußt werden).

Ist der Schaltzustand des Gatters auf "H"-Pegel wird der Transistor 26 über seinen Basiswiderstand durchgesteuert. Der Transistor 26 liegt im Übersteuerungsbereich und bildet eine niederohmige Spannungsquelle 19 mit geringer Spannung und geringem Innenwiderstand in seiner Kollektor-Emitterstrecke. Diese Spannungsquelle 19 liegt am Transistor 13 (Basis Emitter) an und erzeugt bei ausreichender Kollektor-Emitterspannung einen stabilen 1. Durchbruch. Schaltet das Gatter 24 auf "L"-Pegel kommt es zur Triggerung des 2. Durchbruchs, d.h. der Transistor 26 wird gesperrt. Die Spannungsquelle wird hochohmig. Über den Widerstand 20 wird hochohmiger Strom in die Basis des Schaltstreckentransistors 13 eingespeist, der 2. Durchbruch wird gezündet und damit der Durchschaltvorgang ausgelöst.

Beschleunigungskondensatoren nach dem Stand der Technik sind in den Grundschaltungen zur Beschaltung der Widerstände $R_1$, R anwendbar. (z.B. Basis des Transistors 26)

Aufbau und Wirkungsweise von zwei Schaltungsbeispielen zur Kaskadierung von zwei Transistoren 13 für den Durchbruchbetrieb (1. und 2. Durchbruch) zeigen die Fig. 21.1 und 21.2.

Beim ersten Schaltungsbeispiel gemäß Fig. 21.1 wird über einen Vorwiderstand 7 der Ladekondensator C von einer Spannungsquelle 5 aufgeladen.

Wenn die Schaltstrecke, die aus den kaskadierten Transistoren 13.1 und 13.2 besteht, zündet, entlädt sich gemäß der zu den Fig. 15 und 16 erläuterten Zusammenhänge der Ladekondensator 12 über den Emitterwiderstand ($R_E$) 25 mit der Zeitkonstante $R_E * C = \tau_E$.

Zur Triggerung des Zündvorganges: Der Transistor 26 ist durchgesteuert, so daß sich die Kondensatorspannung durch die Teilerwiderstände ($R_T$) 27.1 und 27.2 gleichmäßig auf die Transistoren 13.1 und 13.2 aufteilt. Die an den Transistoren 13.1 und 13.2 anliegenden Spannungen sind kleiner als ihre Durchbruchspannungen (1. und 2. Durchbruch).

Wenn der Steuerimpuls den Transistor 26 sperrt, erhöht sich die Spannung über den Transistor 13.1 auf die Durchbruchspannung des 2. Durchbruchs.

Der Transistor 13.1 zündet auf Grund der Spannungserhöhung seinen 2. Durchbruch. Dadurch steigt am Transistor 13.2. die Spannung sprungartig an und zündet ebenfalls den 2. Durchbruch, d.h. die Schaltstrecke ist durchgezündet, der Ladekondensator 12 entlädt sich schlagartig über den Emitterwiderstand 25. Das Auskoppeln der Störgröße erfolgt wie zu den Fig. 15 und 16 erläutert.

Die Blöcke 28.1. und 28.2 beinhalten Schaltungen nach Fig. 18 (für Block 28.1) bzw. Fig. 17 bis Fig. 19 (für den Block 28.2). Sie dienen der Erzeugung eines definierten Durchbruchverhaltens.

Um auch höhere Spannungen schaltbar zu machen, können weitere Stufen, bestehend aus Schalttransistor 13, Teilerwiderstand 27 und Block 28 kaskadiert werden.

Beim zweiten Schaltungsbeispiel gemäß Fig. 21.2 wird der Ladekondensator C über den Vorwiderstand 7 durch die Spannungsquelle 5 aufgeladen.

Wenn die Schaltstrecke, die aus den kaskadierten Transistoren 13.1 und 13.2 besteht, zündet, entlädt sich der Ladekondensator 12 gemäß der zu den Fig. 15 und 16 erläuterten Zusammenhänge. Ein Emitterwiderstand 25 kann wie in Fig. 21.1 verwendet werden.

Zur Triggerung des Zündvorganges: Über den Teilerwiderstand 27.2 erhöht sich die Spannung am Transistor 13.1 bis zur Spannung des 1. Durchbruchs. Dieser Zustand wird stabil gehalten durch Triggerschaltungen nach Fig. 20 (hier Fig. 20.2).

Der Transistor 13.2 darf seine Durchbruchspannung in diesem Betriebszustand nicht erreichen.

Durch Auslösen der Triggerung mit der Triggerschaltung nach Fig. 20 wird im Transistor 13.1 der 2. Durchbruch gezündet. Dadurch steigt sprungartig die Spannung über dem Transistor 13.2, was ebenfalls zum 2. Durchbruch führt. Die Schaltstrecke bestehend aus den Transistoren 13.1 und 13.2 zündet durch und entlädt den Ladekondensator 12.

Das Auskoppeln der Störgröße erfolgt nach dem zu den Fig. 15 und 16 erläuterten Ablauf. Die Schaltung im Block 28 ist eine Schaltung nach Fig. 17 bis 19 und dient der Erzeugung eines definierten Durchbruchverhaltens.

Auch bei dieser Schaltung können zur Teilschaltstrecke Transistor 13.2, Block 28 und Teilerwiderstand 27.2 weitere Teilschaltstrecken kaskadiert werden (Reihenschaltung).

Durch diese Kaskadierung können zusätzlich höhere Spannungen des Ladekondensators 12 geschaltet und der Arbeitsbereich der zu schaltenden Spannung erweitert werden.

Liste der **Bezugszeichen**:

| | |
|---|---|
| 1 - | Sonde |
| 2 - | Störimpulsgenerator |
| 3 - | Induktionsspule |
| 4 - | Kondensator, Koppelplatten |
| 4.1 - | äußere Koppelplatte |
| 4.2 - | innere Koppelplatte (Gegenplatte) |
| 5 - | Spannungsquelle U |
| 6 - | Bedienelemente |
| 7 - | passive Bauelemente |
| 8 - | Schaltstrecke |
| 9 - | Ringelektrode |
| 10 - | Scheibenelektrode |
| 11 - | Schirmung |
| 12 - | Kondensator C |
| 13 - | Transistor |
| 14 - | Ferritelemente |
| 15 - | Ferritstab |
| 15.1 - | feldabgebende Stirnseite von 15 |
| 16 - | Metallscheibe |
| 17 - | Stabelement aus Iso-material |
| 18 - | Gehäuse(kontur) |
| 19 - | niederohmiges Bauelement |
| 20 - | Widerstand (ohmscher) R |
| 21 - | hochohmige Stromquelle |
| 22 - | Induktivität |
| 23 - | Schalter |
| 24 - | Gatter |
| 25 - | Emitterwiderstand $R_E$ |
| 26 - | Transistor |
| 27 - | Teilerwiderstand $R_T$ |
| 28 - | Schaltung nach Fig. 16 |
| 29 - | U-förmiger Magnetkern |
| 30 - | Widerstand zur Intensitätsverstellung |
| 31 - | Schirmung |
| 32 - | Öffnung in Schirm 31 |
| 33 - | Öffnung in Schirm 31 |
| 34 - | Längsschlitz in Schirm 31 |
| 35 - | Verbindungskabel |
| 36 - | Griffstab |
| 37 - | Steckverbinder |
| 38 - | Isolation |
| 39 - | Gelenk |

**Patentansprüche**

1. Feldquelle zur Untersuchung der elektro-magnetischen Verträglichkeit elektronischer Schaltungen unter Verwendung geeigneter Sonden (1), die an einen Störimpulsgenerator (2) angeschlossen sind, wobei alle Komponenten der Feldquelle in einem das Gerät umschließenden handlichen Gehäuse eingebaut und dabei die jeweilige, ggf. austauschbare Sonde (1) zur Erzeugung lokaler, pulsartiger magnetischer und/oder elektrischer Felder in der Gerätespitze installiert ist, und das Gerät

   - ergonomisch zweckmäßig gestaltet stiftartig ausgebildet ist,
   - Bedienelemente (6) zur Verstellung der Parameter des pulsförmigen Feldes durch Einfügen von passiven Bauelementen R, L, C (7) oder eines Transistors in Emitterschaltung in die Generatorschaltung aufweist, wobei als Verstellparameter die Pulsfrequenz, Anstieg und Amplitude und die Auslösung von Einzelimpulsen vorgesehen sind,
   - mit den folgende prinzipiellen Schaltungen ausgeführt ist:

     a) zur Erzeugung pulsartiger elektrischer Felder besteht die Schaltung aus

   - einer Kapazität C (4), die in die Sonde (1) eingebracht ist und die von einer Spannungsquelle (5) über einen Vorwiderstand $R_v$ (7) aufgeladen wird, wobei zusätzlich zu dieser Kapazität (4), die ausgeführt als Koppelplatte(n) (4) in der Sonde (1) vorhanden ist, eine weitere Kapazität schaltbar ist, und
   - einer parallel zum Kondensator (4) liegenden Schaltstrecke (8);

     b) zur Erzeugung pulsartiger magnetischer Felder besteht die Schaltung aus

   - einem Kondensator C (12) mit Vorwiderstand $R_v$ (7), die in Reihe geschaltet sind mit der Spannungsquelle (5) und der in die Sonde (1) eingebrachten Induktionsspule (3) sowie
   - einer parallel zum Kondensator (12) und zur Induktionsspule (3) liegenden Schaltstrecke (8).

2. Feldquelle nach Anpruch 1, **dadurch gekennzeichnet**, daß die Koppelplatten (4) zur Erzeugung eines pulsförmigen elektrischen Feldes als Ringelektrode (9) und von der Ringelektrode eingeschlossene Scheibenelektrode (10) ausgeführt sind, wobei Ringelektrode und/oder Scheibenelektrode eine kreis- oder eckige Form aufweisen können und beide Elektroden (9, 10) in einer Ebene angeordnet sind.

3. Feldquelle nach Anspruch 2, **dadurch gekennzeichnet**, daß sich bei der scheibenförmigen E-Sonde (1) die ringförmige Außenelektrode (9) als Schirm (11) fortsetzt.

4. Feldquelle nach Anspruch 1, **dadurch gekennzeichnet**, daß zur selektiven Einkopplung von auf kleinem Raum konzentrierten, pulsartigen elektrischen (E)-Feldern die Sonde aus einem metallischen Koppelplattenpaar (4.1, 4.2) besteht, das mit einer elektrischen Isolierung umgeben ist und das Plattenpaar (4.1, 4.2) mit einem Griffstab (36) vorzugsweise starr verbunden ist und jede Koppelplatte (4.1, 4.2) eine elektrische Verbindungsleitung (35) zum Störimpulsgenerator besitzt, die durch den Griffstab (36) an je einen Anschluß des am Ende des Griffstabes befindlichen Steckverbinders (37) führt.

5. Feldquelle nach Anspruch 1, **dadurch gekennzeichnet**, daß zur selektiven Einkopplung von auf kleinem Raum konzentrierten, pulsartigen elektrischen (E)-Feldern eine stirnseitig an der Sonde angeordnete Koppelplatte (4.1) eine Gegenplatte (4.2) besitzt, die ca. 2 ... 3 cm über der Einkoppelplatte (4.1) im Gehäuse vorgesehen ist.

6. Feldquelle nach Anspruch 1, **dadurch gekennzeichnet**, daß zur selektiven Einkopplung von auf kleinem Raum konzentrierten, pulsartigen elektrischen (E)-Feldern die Sonde aus einer metallischen Koppelplatte (4.1) besteht, die mit einer elektrischen Isolierung umgeben ist, und die Koppelplatte (4.1) über ein Gelenk (39) oder ein flexibles Verbindungsstück mit einem Griffstab (36) verbunden ist, und die Beaufschlagung der Koppelplatte (4.1) mit Störspannung bzw. Störstrom eines Burstgenerators über einen am Ende des Griffstabes (36) befindlichen Steckverbinder (37) sowie eine isolierte Leitung im Griffstab (36), die mit der Koppelplatte elektrisch verbunden ist, erfolgt.

7. Feldquelle nach einem der Ansprüche 3 bis 6, **dadurch gekennzeichnet**, daß die Verbindungsleitungen (35) zwischen den Koppelplatten (4.1, 4.2) und dem Störimpulsgenerator (2) zumindest abschnittsweise durch ein Ferritrohr (15) geführt sind.

8. Feldquelle nach Anspruch 1, **dadurch gekennzeichnet**, daß zur Einstellung der Intensität der pulsartigen E- oder B-Felder direkt an den Sonden (1) eine Verstellmöglichkeit vorgesehen ist, die als Widerstand (30), der parallel in die Sondenleitung geschaltet und von außen veränderlich ist, ausgeführt ist.

9. Feldquelle nach Anspruch 1 oder 8, **dadurch gekennzeichnet**, daß zur Bündelung des pulsartigen B-Feldes die an der Sondenspitze befindliche Spule (3) auf das zur Sondenspitze weisende Ende eines Ferritstabes (15) aufgesteckt oder an diesem Ende angebracht ist.

10. Feldquelle nach einem der Ansprüche 1 oder 9, **dadurch gekennzeichnet**, daß zur Bündelung des pulsartigen B-Feldes und zur Gleichtaktunterdrükkung die Zuleitung zur Induktionsspule (3) durch ein Ferritelement (14) geführt ist, wobei die Längsachsen von Spule (3) und Ferritelement (14) übereinstimmen und die Spule sich an das Ferritelement anschließt.

11. Feldquelle nach einem der Ansprüche 1 und 8 bis 10, **dadurch gekennzeichnet**, daß zur selektiven Einkopplung von auf kleinem Raum gebündelten, pulsartigen Magnetfeldern die mit einem Burstgenerator gekoppelte Quelle für lokale Pulsmagnetfelder aus zwei Miniaturinduktionsspulen (3) aufgebaut ist, die in Form einer Acht in der Sondenspitze angeordnet sind.

12. Feldquelle nach einem der Ansprüche 1 und 8 bis 10, **dadurch gekennzeichnet**, daß zur selektiven Einkopplung von auf kleinem Raum gebündelten, pulsartigen Magnetfeldern, in den Sondenkopf ein zur Sondenspitze offener U-förmiger Magnetkern (29) eingebracht ist, auf dem sich eine oder mehrere Miniaturinduktionsspulen (3) befinden.

13. Feldquelle nach einem der Ansprüche 1 und 8 bis 12, **dadurch gekennzeichnet**, daß zur selektiven Einkopplung von auf kleinstem Raum gebündelten pulsartigen Magnetfeldern a) die Induktionsspule (3) auf einem Ferritstab (15) so aufgebracht ist, daß die Induktionsspule (3) erst einige Millimeter hinter der feldabgebenden Stirnseite (15.1) des Ferritstabes (15) oder des Sondenkopfes beginnt und b) ein Schirm (31) bis auf die Öffnung (32) in der Stirnseite der Sonde und mindestens eine weitere Öffnung (33) im hinteren Teil der Sonde, die das Austreten bzw. Eintreten der Magnetfeldlinien ermöglichen, die gesamte Feldsonde umhüllt.

14. Feldquelle nach einem der Ansprüche 1 und 8 bis 12, **dadurch gekennzeichnet**, daß zur selektiven Einkopplung von auf kleinstem Raum gebündelten pulsartigen Magnetfeldern a) die Induktionsspule (3) auf einem Ferritstab (15) so aufgebracht ist, daß die Induktionsspule (3) erst einige Millimeter hinter der feldabgebenden Stirnseite (15.1) des Ferritstabes (15) oder des Sondenkopfes beginnt und b) ein Schirm (31) die gesamte Feldsonde umhüllt, der im Bereich des Ferritstabes (15) einen Längsschlitz

(34) aufweist, der am Sondenkopf (15.1) beginnt und im Bereich des sondeninneren Ferritstabes als erweiterter Schlitz (33) ausgeführt ist.

15. Feldquelle nach Anspruch 1,
**dadurch gekennzeichnet**, daß die Schaltstrecke (8) aus einer einfachen Funkenstrecke oder einem Transistor (13) besteht, wobei der Transistor (13) im Durchbruchsbereich unter Nutzung des Avalancheeffektes betrieben wird.

16. Feldquelle nach Anspruch 15,
**dadurch gekennzeichnet**, daß die als Funkenstrecke ausgeführte Schaltstrecke (8) aus einem edelgasgefüllten Überspannungsableiter besteht.

17. Feldquelle nach Anspruch 15,
**dadurch gekennzeichnet**, daß zur definierten Erzeugung des 1. Durchbruchs des Transistors (13) ein für Wechselspannung niederohmiges Bauelement (19) zwischen Basis und Emitter geschaltet ist, wobei als ein solches für Wechselspannung niederohmiges Bauelement (19) eine niederohmige Spannungsquelle einsetzbar ist und die Spannung der Spannungsquelle (19) zwischen negativen Werten, Null und der Flußspannung der Basis-Emitterdiode des Transistors (13) zu steuern ist.

18. Feldquelle nach Anspruch 15,
**dadurch gekennzeichnet**, daß zur Erzeugung eines stabilen 2. Durchbruchs des Transistors (13) die Basis des Transistors mit einem für Wechselstrom hochohmigen Widerstand (21) beschaltet ist.

19. Feldquelle nach Anspruch 15,
**dadurch gekennzeichnet**, daß zur Triggerung des 2. Durchbruchs in die Basis des Transistors (13) über einen Triggerschalter (23) ein Strom einer hochohmigen Stromquelle (21) eingespeist wird, wobei diese Stromquelle (21) insbesondere einen für Wechselstrom hochohmigen Innenwiderstand besitzt.

20. Feldquelle nach Anspruch 15,
**dadurch gekennzeichnet**, daß zur Erzeugung eines stabilen 1. Durchbruchs und zur Triggerung des 2. Durchbruchs die Basis des in der Schaltstrecke liegenden Transistors (13), gesteuert durch einen Triggerschalter (23), entweder an eine niederohmige Spannungsquelle (19) oder eine hochohmige Stromquelle (21) geschaltet ist.

21. Feldquelle nach Anspruch 20,
**dadurch gekennzeichnet**, daß gesteuert von einem Gatter (24) als insbesondere für Wechselstrom niederohmiges Bauelement (19) eine Diode eingesetzt ist und als hochohmige Stromquelle (21) ein an der Hilfsspannung $V_{cc}$ liegender Widerstand (20) der Basis des Transistors (13) vorgeschaltet ist.

22. Feldquelle nach Anspruch 21,
**dadurch gekennzeichnet**, daß zusätzlich ein Emitterwiderstand (25) in den Stromkreis der Schaltstrecke mit Transistor (13) eingefügt ist und als für Wechselspannung niederohmiges Bauelement (19) ein Transistor (26) mit geringem Innenwiderstand in seiner Kollektor-Emitterstrecke an die Basis-Emitter-Anschlüsse des Schalttransistors (13) angeklemmt ist.

23. Feldquelle nach einem der Ansprüche 17 bis 20 und 22,
**dadurch gekennzeichnet**, daß zur Erweiterung des Arbeitsbereiches der Schaltstrecke für größere variierbare Spannungen zwei oder mehrere Transistoren (13) für den Durchbruchbetrieb (1. und 2 Durchbruch) kaskadiert werden, wobei diese und jede weitere Kaskadenstufe aus einem Schalttransistor (13), ggf. einem Teilerwiderstand (27) und einem Block (28) zur Beschaltung der Transistorbasis besteht, und dabei die Beschaltung des ersten Transistors den zweiten Durchbruch des ersten Transistors bewirkt, wobei die Initialisierung des Durchbruchs durch Triggerung der Basis oder durch Erhöhung der Kollektor-Emitter-Spannung bis auf die Durchbruchsspannung erfolgt.

FIG. 1.1        FIG. 1.2

EP 0 729 035 A2

FIG. 2

EP 0 729 035 A2

FIG. 3

FIG. 4

15

FIG. 5.1

FIG. 5.2

FIG. 6

FIG. 7

FIG. 8

FIG. 9.1

FIG. 9.2

$\vec{B}$

3    15

15.1

10.1

$\vec{B}$

10.2

FIG. 10

FIG. 11.1

FIG. 12.1

FIG. 11.2

FIG. 12.2

# FIG. 13

FIG. 14

EP 0 729 035 A2

FIG. 15.1

FIG. 15.2

FIG. 16.1

FIG. 16.2

FIG. 16.3

FIG. 16.4

FIG. 17.2

FIG. 17.1

FIG. 18

FIG. 19.1

FIG. 19.2

EP 0 729 035 A2

Trigger

FIG. 20.1

FIG. 20.2

FIG. 20.3

FIG. 21.1

EP 0 729 035 A2

FIG. 21.2

FIG. 20.2

$V_{CC}$

27.2

13.2

28

$R_{T2}$

$R_V$
7

5

12

C

13.1

EP 0 729 035 A2